# EUROPEAN PATENT SPECIFICATION

(11) **EP 2 022 825 B1**
(45) Date of publication and mention of the grant of the patent: **27.01.2010**
(21) Application number: 07742911.6
(22) Date of filing: 07.05.2007
(51) Int. Cl.: C08L 45/00, B32B 15/08, C08L 53/02, C08L 65/00

(54) **MATERIAL FOR ELECTRONIC PART FOR HIGH-FREQUENCY USE AND ELECTRONIC PART FOR HIGH-FREQUENCY USE COMPRISING THE MATERIAL**
MATERIAL FÜR EIN ELEKTRONISCHES TEIL ZUR HOCHFREQUENZ-VERWENDUNG UND ELEKTRONISCHES TEIL ZUR HOCHFREQUENZ-VERWENDUNG ENTHALTEND DIESES MATERIAL
MATÉRIAU POUR ÉLÉMENT ÉLECTRONIQUE À USAGE À HAUTE FRÉQUENCE ET ÉLÉMENT ÉLECTRONIQUE À USAGE À HAUTE FRÉQUENCE COMPRENANT LE MATÉRIAU

(30) Priority: 09.05.2006 JP 2006129825
(43) Date of publication of application: 11.02.2009
(73) Proprietor: Polyplastics Co., Ltd., Tokyo 108-8280 (JP)
(72) Inventor: KUNIMOTO, Eiki, Fuji-shi, Shizuoka 416-8533 (JP); MIYAZAKI, Hirotaka, Fuji-shi, Shizuoka 416-8533 (JP)
(74) Representative: Ackermann, Joachim
(86) International application number: PCT/JP2007/059476
(87) International publication number: WO 2007/129694

(56) References cited:
- EP-A- 1 449 882
- JP-A- 01 256 548
- JP-A- 06 001 895
- JP-A- 2001 011 247
- JP-A- 2001 011 248
- JP-A- 2003 115 645
- JP-A- 2006 352 470
- US-A1- 2004 236 024

## Description

### TECHNICAL FIELD

The present invention relates to a material for high-frequency use electronic parts, and a high-frequency use electronic part including the material. More specifically, the present invention relates to a material for high-frequency use electronic parts which includes a particular elastomer ingredient and a cycloolefin resin having a cycloolefin component as a copolymer component, and which has dielectric properties suitable for use in a high-frequency region, satisfying suitability for plating, high adhesion to metal deposit layers and also superior impact resistance. Furthermore, the present invention also relates to a high-frequency use electronic part including the material.

### BACKGROUND ART

Cycloolefin resins are resins having a cyclic olefin skeleton in their main chain and having properties including high transparency, low birefringence, high heat deformation temperature, light weight, dimensional stability, low water-absorbency, hydrolysis resistance, chemical resistance, low-dielectric constant, low-dielectric loss, freedom from materials which present environmental problems. Consequently, cycloolefin resins are used in various fields requiring the aforementioned properties.

Among all, in terms of capabilities of achieving superior dielectric properties, heat resistance and solvent resistance, the cycloolefin resins have been used as polymer insulation materials such as circuit boards, and electronic parts.

For example, Patent Document 1 proposes a curable composition including a cycloolefin resin, a curing agent and a thiol compound. According to the curable composition disclosed in Patent Document 1, a circuit board can be manufactured which is superior in insulation resistance, peel resistance, heat resistance and chemical resistance.

Furthermore, in Patent Documents 2 and 3, a crosslinkable resin composition including a cycloolefin resin, an organic peroxide and a crosslinking accelerator is proposed. The molded product obtained by crosslinking the resin composition disclosed in Patent Document 2 or 3 is superior in low dielectric properties in a high-frequency region, heat resistance and chemical resistance. In addition, the molded product has a low coefficient of linear expansion and water absorption, while having high mechanical strength. Therefore, such molded products have been deemed useful as high-frequency circuit boards.

However, the cycloolefin resins have been problematic in terms of fragility and inferior impact resistance, irrespective of many advantageous features as described above. Accordingly, a method for improving impact resistance is proposed by, for example, forming an alloy with a rubber ingredient that is incompatible with the cycloolefin resin (refer to Patent Document 4).
Patent Document 1: Japanese Unexamined Patent Application, First Publication No. 2001-064517
Patent Document 2: Japanese Unexamined Patent Application, First Publication No. Hei 06-248164
Patent Document 3: Japanese Unexamined Patent Application, First Publication No. 2003-238761
Patent Document 4: Japanese Unexamined Patent Application, First Publication No. Hei 11-021413

### DISCLOSURE OF THE INVENTION

### Problems to be Solved by the Invention

However, the curable composition disclosed in Patent Document 1 has a high dielectric dissipation factor (tan δ) and a high relative dielectric constant (ε') in a high-frequency region, and thus dielectric properties in the high-frequency region are unsatisfactory. With advances in the recent highly information-oriented society, the frequency of signals used in communication and electronic devices has shifted from the megahertz zone to the gigahertz zone. In general, transmission loss of electrical signals tends to be greater as the frequency rises, and thus development of an electrical insulating material having superior high-frequency transmission characteristics corresponding to the high-frequency region has been desired.

In addition, although the crosslinkable composition disclosed in Patent Documents 2 and 3 has superior dielectric properties in the high-frequency region, the deposit layer itself may not be formed in some cases since sufficient plating adhesive properties cannot be provided. Since cycloolefinic cured products essentially have a chemically inactive structure, they do not have satisfactory metal plating adhesive properties. However, conductor layers in wiring boards and the like are usually formed by affixing a metallic foil or plating on the substrate surface. In particular, nonelectrolytic plating has been selected when the plating is to be subjected to through holes. Furthermore, when a wiring board is laminated while allowing an electrical insulating layer to intervene between the layers by a build-up process as in the case of build-up substrates, it is difficult to form the build-up layer itself when the plating adhesive properties are inferior.

Moreover, according to the composition disclosed in Patent Document 4, although the impact resistance needed for medical applications and packing applications may be satisfactory to some extent, additional impact resistance can be required depending on the application. For example, improvement of the impact resistance can be one of the important factors in realizing super-long life of electronic devices. With respect to external shock and the like following packing, impact resistance of the electrical insulating material itself constituting the substrate plays an important role. Resulting from low impact resistance of the electrical insulating material, a crack may be generated, and thus problems such as disconnection, fracture and the like may be raised.

The present invention was made in view of the foregoing problems, and an object of the invention is to provide a material for high-frequency use electronic parts which has dielectric properties suitable for use in a high-frequency region, suitable for plating, high adhesion to metal deposit layers and also superior impact resistance without loss of intact various properties of a cycloolefin resin, and to an high-frequency use electronic part which includes the material. Means for Solving the Problems

The present inventors have thoroughly researched in order to solve the above-described problems. Focusing on an elastomer ingredient for the purpose of improving the impact resisting strength. As a result, it was found that the aforementioned problems can be solved by defining the blending proportion of the cycloolefin resin to the elastomer ingredient, and the proportion of unsaturated double bonds contained in the elastomer ingredient to fall within a specific range. Accordingly, the present invention was achieved. More specifically, the present invention provides the following.

According to a first aspect of the present invention, a material for high-frequency use electronic parts is provided which includes no less than 60 parts by mass and no more than 90 parts by mass of (A) a cycloolefin resin containing a cycloolefin component as a copolymer component, and no less than 10 parts by mass and no more than 40 parts by mass of (B) an elastomer ingredient, in which the content of the unsaturated double bonds in the elastomer ingredient (B) determined by an iodine value method (in accordance with JIS K 6235) is no less than 4 × 10⁻⁴ mol/g and no greater than 23 × 10⁻⁴ mol/g, and the dielectric loss (tan δ) of the molded product composed of the material for high-frequency use electronic parts measured according to determination by cavity resonance with a method of perturbation at 1 to 10 GHz is no greater than 13 × 10⁻⁴.

The material for high-frequency use electronic parts of the first aspect includes no less than 10 parts by mass and no more than 40 parts by mass of the elastomer ingredient (B). The amount of the blended elastomer ingredient (B) of less than 10 parts by weight is not preferred since impact strength may be too low. In contrast, when the amount exceeds 40 parts by weight, an alloy structure in which the elastomer is dispersed in the cycloolefin resin (A) cannot be stably obtained, whereby a problem in moldability may be raised.

Furthermore, the material for high-frequency use electronic parts of the first aspect has a content of the unsaturated double bonds in the elastomer ingredient (B) of no less than 4 × 10⁻⁴ mol/g and no greater than 23 × 10⁻⁴ mol/g. The "content of the unsaturated double bonds" referred to herein means an iodine value determined by an iodine value method (in accordance with JIS K 6235).

In the present invention, a content of the unsaturated double bonds in the elastomer ingredient (B) of less than 4 × 10⁻⁴ mol/g is not preferred due to inferior productivity since the etching time period is prolonged. In general, an increase in the content of the unsaturated double bonds in the elastomer ingredient (B) is responsible for improvement of suitability for plating and the plating adhesion. However, when the content of the unsaturated double bonds in the elastomer ingredient (B) is greater than 23 × 10⁻⁴ mol/g, the dielectric loss described below may be so large that it is not preferred as a material for high-frequency use electronic parts. Therefore, in the present invention, it is necessary to define the content of the unsaturated double bonds in the elastomer ingredient (B) to fall within the above range in light of achievement of both required physical properties, i.e. the suitability for plating and plating adhesion, and the dielectric properties in the high-frequency region.

The dielectric loss (tan δ) measured according to determination by cavity resonance with a method of perturbation at 1 to 10 GHz of the material for high-frequency use electronic parts of the present invention is no greater than 13 × 10⁻⁴. The dielectric loss (tan δ) referred to herein means tan δ derived by measurement according to determination by cavity resonance with a method of perturbation.

In general, high dielectric loss (tan δ) may lead to attenuation in a high-frequency range, and particularly, the dielectric loss has a great effect in the high-frequency region of the GHz band. Accordingly, it is necessary for the dielectric loss (tan δ) in 1 to 10 GHz to be no greater than 13 × 10⁻⁴. Since the molded product obtained from the material for high-frequency use electronic parts of the present invention exhibits dielectric loss (tan δ) at 1 to 10 GHz, preferably at 5.8 GHz, of no greater than 13 × 10⁻⁴, it can be suitably used as a high-frequency use electronic part.

As in the foregoing, the material for high-frequency use electronic parts of the first aspect having a specific composition and including the specific ingredients has dielectric properties suitable for use in a high-frequency region while retaining intact various properties of a cycloolefin resin, and is accompanied by suitability for plating, high adhesion to metal deposit layers and also superior impact resistance.

According to a second aspect, the elastomer ingredient (B) includes styrene as a polymer component in the material for high-frequency use electronic parts according to the first aspect.

The cycloolefin resin includes a cycloolefin as its skeletal component. Since the cycloolefin has a structure and polarity similar to those of the components having an aromatic skeleton such as styrene, it is highly miscible with these components. Because the material for high-frequency use electronic parts according to the second aspect includes styrene as a polymer component of the elastomer ingredient (B), the elastomer ingredient (B) is readily admixed with and dispersed in the cycloolefin resin (A). Thus, the material for high-frequency use electronic parts according to the second aspect can further improve the impact resistance, suitability for plating and plating adhesion resulting from the elastomer ingredient (B).

According to a third aspect, in the material for high-frequency use electronic parts according to the first or second aspect, the elastomer ingredient (B) is a mixture of (b1) an elastomer having unsaturated bonds and (b2) an elastomer not substantially having an unsaturated bond.

The material for high-frequency use electronic parts according to the third aspect includes a mixture of (b1) an elastomer having unsaturated bonds and (b2) an elastomer not substantially having an unsaturated bond as the elastomer ingredient (B).

Herein, the term "(b2) an elastomer not substantially having an unsaturated bond" means to include, in addition to an elastomer not having an unsaturated bond immediately after the polymerization, also a hydrogenated elastomer obtained by hydrogenation of the unsaturated bonds of an elastomer having unsaturated bonds. When a part of the unsaturated bond of the elastomer having unsaturated bonds is hydrogenated, while a part of the unsaturated bond remains unchanged, such an elastomer ingredient may be referred to as a mixture of the elastomer having unsaturated bonds (b1) and the elastomer not substantially having an unsaturated bond (b2).

In other words, the term "a mixture of (b1) an elastomer having unsaturated bonds and (b2) an elastomer not substantially having an unsaturated bond" to be the elastomer ingredient (B) in the material for high-frequency use electronic parts according to the third aspect may be: a blend of an elastomer having unsaturated bonds and an elastomer not having an unsaturated bond; an elastomer having unsaturated bonds in which a part of the unsaturated bond is hydrogenated; or an elastomer not having an unsaturated bond partially oxidized to have a predetermined content of the unsaturated bond.

In general, when the elastomer having unsaturated bonds (b1) is blended with the cycloolefin resin (A), solubility into an etchant in etching, which is a preliminary process of plating, may be so high that the dielectric properties in the high-frequency region may be inferior although superior suitability for plating and plating adhesion can be achieved. In contrast, when an elastomer not having an unsaturated bond (b2) is blended, impact properties can be improved in the state of retaining the dielectric properties in the high-frequency region although the solubility into an etchant may be low.

Therefore, in the material for high-frequency use electronic parts according to the third aspect, by using as the elastomer ingredient (B) a mixture of both the elastomer having unsaturated bonds (b1) and the elastomer not substantially having an unsaturated bond (b2), both required physical properties, i.e. dielectric properties in a high-frequency region, and suitability for plating and plating adhesion, can be achieved.

According to a fourth aspect, in the material for high-frequency use electronic parts according to any one of the first to third aspects, the elastomer ingredient (B) is a mixture including (b1') a styrene copolymer and (b2') a hydrogenated product of the styrene copolymer.

In the material for high-frequency use electronic parts according to the fourth aspect, a mixture including (b1') a styrene copolymer and (b2') a hydrogenated product of the styrene copolymer is used as the elastomer ingredient (B). As described above, the styrene copolymer is readily admixed with and dispersed in the cycloolefin resin (A).

Thus, when a certain styrene copolymer (b1') and a hydrogenated product of this styrene copolymer (b2') are used as the elastomer ingredient (B), high miscibility of these elastomer ingredients can be achieved, and they can be readily dispersed in the cycloolefin resin (A). Therefore, homogenous dispersibility of the elastomer ingredient (B) in the cycloolefin resin (A) can be provided. Accordingly, the impact resistance, and the suitability for plating and plating adhesion resulting from the elastomer ingredient (B) can be more uniformly provided.

According to a fifth aspect, the elastomer ingredient (B) is a mixture including (b1'') a styrene-butadiene-styrene block copolymer (hereinafter, may be also referred to as SBS) and (b2'') a styrene-ethylene · butylene-styrene block copolymer (hereinafter, may also be referred to as SEBS) in the material for high-frequency use electronic parts according to any one of the first to fourth aspects.

In the material for high-frequency use electronic parts according to the fifth aspect, a mixture including SBS and SEBS is used as the elastomer ingredient (B). The abbreviation SEBS herein means a hydrogenated product of SBS. Thus, miscibility of SBS and SEBS is high, and similar dispersibility is exhibited in the cycloolefin (A). Therefore, the material for high-frequency use electronic parts according to the fifth aspect that includes such an elastomer ingredient (B) has improved impact resistance, suitability for plating and plating adhesion resulting from the elastomer ingredient (B).

According to a sixth aspect, the material for high-frequency use electronic parts according to any one of the first to fifth aspects has a Charpy impact value determined in accordance with ISO179/1eA of no less than 20 kJ/m².

The Charpy impact value is one of the indices representing impact resistance. When the Charpy impact value is low, breakage of the molded product in assembly, and breakage of the molded product during use due to impact and the like can be easily caused. Accordingly, the Charpy impact value of the high-frequency use electronic parts is desired to be no less than 20 kJ/m². Since the molded product obtained from the material for high-frequency use electronic parts according to the sixth aspect has a Charpy impact value of no less than 20 kJ/m², it can be suitably used as an high-frequency use electronic part.

According to a seventh aspect, the material for high-frequency use electronic parts according to any one of the first to sixth aspects has an adhesion strength of plating being no less than 0.6 N/mm, as determined when the material is formed into a molded product having a length of 70 mm, a width of 70 mm and a thickness of 2 mm, and subjected to etching at 60°C for no longer than 1 hour in an aqueous chromic acid solution that is a mixture of 300 g/L chromic acid and 350 g/L sulfuric acid.

Generally, in high-frequency use electronic parts, there may be a case in which the plating peels when the plating adhesion is low due to expansion and contraction of the molded product in response to variation of ambient temperatures, and friction in assembling. Therefore, the adhesion strength of plating is desired to be no less than 0.6 N/mm as determined after subjecting to etching at 60°C for no longer than 1 hour in an aqueous chromic acid solution that is a mixture of 300 g/L chromic acid and 350 g/L sulfuric acid . Since the molded product obtained from the material for high-frequency use electronic parts according to the seventh aspect has an adhesion strength of plating being no less than 0.6 N/mm, the peeling of the plating can be sufficiently prevented even in variations of ambient temperatures, and in assembly of the high-frequency use electronic parts composed of the molded product.

According to an eighth aspect, a high-frequency use electronic part is composed of the material for high-frequency use electronic parts according to any one of the first to seventh aspects.

It is preferred that high-frequency use electronic parts have dielectric properties suitable for use in a high-frequency region, satisfying suitability for plating and high adhesion to metal deposit layers, and also superior impact resistance. According to the material for high-frequency use electronic parts of the present invention, such requirements can be satisfied with favorable balance, and thus a superior high-frequency use electronic part can be provided.

According to a ninth aspect, the high-frequency use electronic part according to the eighth aspect is subjected to metal plating on at least a part of the surface and/or the interior.

Since the high-frequency use electronic part according to the ninth aspect satisfies suitability for plating and has high adhesion to metal deposit layers, particularly superior durability can be provided as compared with parts composed of other material, when the part is subjected to metal plating on at least a part of the surface thereof.

### Effects of the Invention

The material for high-frequency use electronic parts of the present invention has dielectric properties suitable for use in a high-frequency region while retaining intact various properties of a cycloolefin resin, and is accompanied by satisfying suitability for plating, high adhesion to metal deposit layers and also superior impact resistance. Thus, the molded product composed of the material for high-frequency use electronic parts of the present invention can be suitably used as a high-frequency use electronic part.

### PREFERRED MODE FOR CARRYING OUT THE INVENTION

Hereinafter, embodiments of the present invention will be explained.

### Material for High-frequency Use Electronic Parts

The material for high-frequency use electronic parts of the present invention includes a composition that includes as essential ingredients (A) a cycloolefin resin containing a cycloolefin component as a copolymer component, and (B) an elastomer ingredient.

### (A) Cycloolefin Resin

The cycloolefin resin (A) to be an essential ingredient of the material for high-frequency use electronic parts of the present invention is described below. The cycloolefin resin (A) used in the present invention contains a cycloolefin component as a copolymer component, and is not particularly limited as long as it is a polyolefin resin containing a cycloolefin component in the main chain thereof. For example,
(a1) an addition polymer of cycloolefin or a hydrogenated product thereof,
(a2) an addition copolymer of cycloolefin and α-olefin or a hydrogenated product thereof, and
(a3) a ring-opening (co)polymer of cycloolefin or a hydrogenated product thereof can be exemplified.
   Moreover, the cycloolefin resin (A) containing a cycloolefin component used in the present invention as a copolymer component includes
   (a4) any of the resins of the above (a1) to (a3) being grafted and/or copolymerized with an unsaturated compound having a polar group.

The polar group can include, for example, carboxyl groups, acid anhydride groups, epoxy groups, amide groups, ester groups, hydroxyl groups, or the like. Examples of the unsaturated compound having a polar group include (meth)acrylic acid, maleic acid, maleic anhydride, itaconic anhydride, glycidyl (meth)acrylate, (meth)acrylic acid alkyl (1 to 10 carbon atoms) esters, maleic acid alkyl (1 to 10 carbon atoms) esters, (meth)acrylamide, 2-hydroxyethyl (meth)acrylate, and the like.

In the present invention, one kind alone or a mixture of two or more kinds of the cycloolefin resins containing the cycloolefin component described above (a1)-(a4) as a copolymer component may be used. In the present invention, the addition copolymer of cycloolefin and α-olefin, or a hydrogenated product thereof (a2) can be preferably used.

In addition, a commercially available resin can be used for the cycloolefin resin containing a cycloolefin component as a copolymer component which may be used in the present invention. The commercially available cycloolefin resins can include, for example, TOPAS (registered trademark, manufactured by Ticona, Germany), Apel (registered trademark, manufactured by Mitsui Chemical Co.), ZEONEX (registered trademark, manufactured by ZEON Corp.), ZEONOR (registered trademark, manufactured by ZEON Corp.), ARTON (registered trademark, manufactured by JSR Corp.), and the like.

The addition copolymer of cycloolefin and α-olefin (a2) preferably used in the composition of the present invention is not particularly limited. Particularly preferable examples include copolymers containing [1] an α-olefin component having 2 to 20 carbon atoms and [2] a cycloolefin component represented by the following general formula (I): 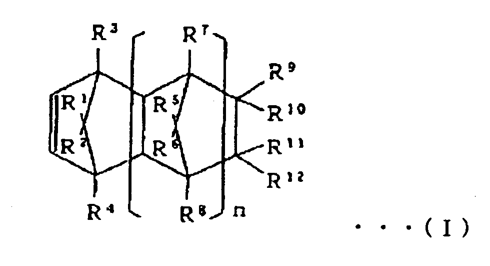 in which,
R¹ to R¹² may be the same or different from one another, and are each selected from the group consisting of a hydrogen atom, a halogen atom and a hydrocarbon group;
R⁹ and R¹⁰, and R¹¹ and R¹² may be combined to form a bivalent hydrocarbon group;
R⁹ or R¹⁰ may form a ring with R¹¹ or R¹² with each other;
n represents 0 or a positive integer; and
when n is 2 or greater, R⁵ to R⁸ may be the same or different from one another, in each repeating unit.

### [1] α-Olefin Component having 2 to 20 Carbon Atoms

The α-olefin having 2 to 20 carbon atoms preferably used in the present invention, which serves as a copolymer component of the addition polymer that is formed by copolymerization of the cycloolefin component and other copolymer component such as ethylene, is not particularly limited. For example, ethylene, propylene, 1-butene, 1-pentene, 1-hexene, 3-methyl-1-butene, 3-methyl-1-pentene, 3-ethyl-1-pentene, 4-methyl-1-pentene, 4-methyl-1-hexene, 4,4-dimethyl-1-hexene, 4,4-dimethyl-1-pentene, 4-ethyl-1-hexene, 3-ethyl-1-hexene, 1-octene, 1-decene, 1-dodecene, 1-tetradecene, 1-hexadecene, 1-octadecene, 1-eicosene and the like can be included. These α-olefin components may be used alone, or two or more kinds thereof may be used simultaneously. Among these, use of ethylene alone is most preferred.

### [2] Cycloolefin Component Represented by the General Formula (I)

The cycloolefin component represented by the general formula (I) preferably used in the present invention, which serves as a copolymer component in the addition polymer that is formed by copolymerization of the cycloolefin component and other copolymer components such as ethylene, are described.

In the general formula (I), R¹ to R¹² may be the same or different from one another, and are each selected from the group consisting of a hydrogen atom, a halogen atom, and a hydrocarbon group.

Specific examples of R¹ to R⁸ can include, e.g., a hydrogen atom; halogen atoms such as fluorine, chlorine, and bromine; low alkyl groups such as a methyl group, an ethyl group, a propyl group and a butyl group, and the like. These may be entirely different, partially different, or entirely the same.

In addition, specific examples of R⁹ to R¹² can include, e.g., a hydrogen atom; halogen atoms such as fluorine, chlorine, and bromine; alkyl groups such as a methyl group, an ethyl group, a propyl group, an isopropyl group, a butyl group, an isobutyl group, a hexyl group, and a stearyl group; cycloalkyl groups such as a cyclohexyl group; substituted or unsubstituted aromatic hydrocarbon groups such as a phenyl group, a tolyl group, an ethylphenyl group, an isopropylphenyl group, a naphthyl group, and an anthryl group; a benzyl group; a phenethyl group, and aralkyl groups formed by substitution of an alkyl group with an aryl group, and the like. These may be different from one another, partially different, or entirely the same.

Specific examples of the case in which R⁹ and R¹⁰, or R¹¹ and R¹² are combined to form a bivalent hydrocarbon group include, for example, alkylidene groups such as an ethylidene group, a propylidene group and an isopropylidene group, and the like.

When R⁹ or R¹⁰ forms a ring with R¹¹ or R¹² by joining each other, the resultant ring may be either monocyclic or polycyclic, may be polycyclic having crosslinking, may be a ring having a double bond, or may be a ring constituted with any combination of these rings. In addition, these rings may include a substituent group such as a methyl group.

Specific examples of the cycloolefin component represented by the general formula (I) include a bicyclic cycloolefin such as bicyclo[2.2.1]hept-2-ene (common name: norbornene), 5-methyl-bicyclo[2.2.1]hept-2-ene, 5,5-dimethylbicyclo[2.2.1]hept-2-ene, 5-ethyl-bicyclo[2.2.1]hept-2-ene, 5-butyl-bicyclo[2.2.1]hept-2-ene, 5-ethylidenebicyclo[2.2.1]hept-2-ene, 5-hexyl-bicyclo[2.2.1]hept-2-ene, 5-octyl-bicyclo[2.2.1]hept-2-ene, 5-octadecylbicyclo[2.2.1]hept-2-ene, 5-methylidene-bicyclo[2.2.1]hept-2-ene, 5-vinyl-bicyclo[2.2.1]hept-2-ene and 5-propenylbicyclo[2.2.1]hept-2-ene;
tricyclic cycloolefin such as tricyclo[4.3.0.1^{2,5}]deca-3,7-diene (common name: dicyclopentadiene), tricyclo[4.3.0.1^{2,5}]dec-3-ene; tricyclo[4.4.0.1^{2,5}]undeca-3,7-diene or tricyclo[4.4.0.1^{2,5}]undeca-3,8-diene, or tricyclo[4.4.0.1^{2,5}]undec-3-ene that is a partially hydrogenated product (or an adduct of cyclopentadiene and cyclohexene) thereof; 5-cyclopentyl-bicyclo[2.2.1]hept-2-ene, 5-cyclohexyl-bicyclo[2.2.1]hept-2-ene, 5-cyclohexenylbicyclo[2.2.1]hept-2-ene and 5-phenylbicyclo[2.2.1]hept-2-ene;
tetracyclic cycloolefin such as: tetracyclo[4.4.0.1^{2,5}.1^{7,10}]dodec-3-ene (also merely referred to as tetracyclododecene), 8-methyltetracyclo[4.4.0.1^{2,5}.1^{7,10}]dodec-3-ene, 8-ethyltetracyclo[4.4.0.1^{2,5}.1^{7,10}]dodec-3-ene, 8-methylidenetetracyclo[4.4.0.1^{2,5}.1^{7,10}]dodec-3-ene, 8-ethylidenetetracyclo[4.4.0.1^{2,5}.1^{7,10}]dodec-3-ene, 8-vinyltetracyclo[4,4.0.1^{2,5}.1^{7,10}]dodec-3-ene and 8-propenyltetracyclo[4.4.0.1^{2,5}.1^{7,10}]dodec-3-ene;
polycyclic cycloolefin, such as 8-cyclopentyltetracyclo[4.4.0.1^{2,5}.1^{7,10}]dodec-3-ene, 8-cyclohexyltetracyclo[4.4.0.1^{2,5}.1^{7,10}]dodec-3-ene, 8-cyclohexenyltetracyclo[4.4.0.1^{2,5}.1^{7,10}]dodec-3-ene, 8-phenyl-cyclopentyltetracyclo[4.4.0.1^{2,5}.1^{7,10}]dodec-3-ene; tetracyclo[7.4.1^{3,6}.0^{1,9}.0^{2,7}]tetradeca-4,9,11,13-tetraene (also referred to as 1,4-methano-1,4,4a,9a-tetrahydrofluorene), tetracyclo[8.4.1^{4,7}.0^{1,10}.0^{3,8}]pentadeca-5,10,12,14-tetraene (may be also referred to as 1,4-methano-1,4,4a,5,10,10a-hexahydroanthracene); pentacyclo[6.6.1.1^{3,6}.0^{2,7}.0^{9,14}]-4-hexadecene, pentacyclo[6.5.1.1^{3,6}.0^{2,7}.0^{9,13}]-4-pentadecene, pentacyclo[7.4.0.0^{2,7}.1^{3,6}.1^{10,13}]-4-pentadecene;heptacyclo[8.7.0.1^{2,9}.1^{4,7}.1^{11,17}.0^{3,8}.0^{12,16}]-5-eicosene, heptacyclo[8.7.0.1^{2,9}.0^{3,8}.1^{4,7}.0^{12,17}.1^{13,16}]-14-eicosene; tetramers of cyclopentadiene; and the like.

These cycloolefin components may be used alone or in combinations of two or more kinds thereof. Among them, use of bicyclo[2.2.1]hept-2-ene (common name: norbornene) alone is preferable.

The method for polymerizing [1] an α-olefin component having 2 to 20 carbon atoms and [2] a cycloolefin component represented by the following general formula (I), and the method for hydrogenating the resultant polymer are not especially limited, and can be carried out according to publicly known methods. Although it may be carried out by either random copolymerization or block copolymerization, random copolymerization is preferable.

In addition, the polymerization catalyst that may be used is not particularly limited, and the polymer can be obtained by using a conventionally well-known catalyst such as a Ziegler-Natta series, metathesis series, or metallocene series catalyst according to a well known process. The addition copolymer of cycloolefin and α-olefin or the hydrogenated product thereof that is favorably used in the present invention is preferably manufactured by use of a metallocene series catalyst.

An exemplary metathesis catalyst may be a molybdenum or tungsten series metathesis catalyst that is well-known as a catalyst for ring-opening polymerization of cycloolefin (for example, as described in Japanese Unexamined Patent Applications, First Publication Nos. 58-127728, 58-129013, etc.). In addition, the polymer obtained with the metathesis catalyst is preferably hydrogenated using a transition metal catalyst supported on an inorganic support, at a rate of no less than 90% of the double bond in the main chain, and at a rate of no less than 98% of the carbon-carbon double bond in the aromatic ring of the side chain.

### Other Copolymer Components

The addition copolymer of cycloolefin and α-olefin (a2), particularly preferably used in the composition of the present invention, may contain, in addition to the α-olefin component having 2 to 20 carbon atoms [1] and the cycloolefin component represented by the general formula (I) [2], other copolymerizable unsaturated monomer components as needed within a range not to impair the object of the present invention.

The unsaturated monomer, which may be optionally copolymerized, is not particularly limited, and for example, hydrocarbon based monomers including two or more carbon-carbon double bonds in one molecule and the like may be exemplified. Specific examples of the hydrocarbon based monomer including two or more carbon-carbon double bonds in one molecule include: linear unconjugated diene such as 1,4-hexadiene, 1,6-octadiene, 2-methyl-1,5-hexadiene, 4-methyl-1,5-hexadiene, 5-methyl-1,5-hexadiene, 6-methyl-1,5-heptadiene and 7-methyl-1,6-octadiene; cyclic unconjugated diene such as cyclohexadiene, dicyclopentadiene, methyltetrahydroindene, 5-vinyl-2-norbornene, 5-ethylidene-2-norbornene, 5-methylene-2-norbornene, 5-isopropylidene-2-norbornene, 6-chloromethyl-5-isopropenyl-2-norbornene and 4,9,5,8-dimethano-3a,4,4a,5,8,8a,9,9a-octahydro-1H-benzoindene; 2,3-diisopropylidene-5-norbornene; 2-ethylidene-3-isopropylidene-5-norbornene;2-propenyl-2,2-norbornadiene; and the like. Among them, 1,4-hexadiene, 1,6-octadiene, and cyclic unconjugated diene, in particular, dicyclopentadiene, 5-ethylidene-2-norbornene, 5-vinyl-2-norbornene, 5-methylene-2-norbornene, 1,4-hexadiene, and 1,6-octadiene are preferable.

### (B) Elastomer Ingredient

Next, the elastomer ingredient (B) used in the material for high-frequency use electronic parts of the present invention is described. The elastomer ingredient (B) used in the material for high-frequency use electronic parts of the present invention has a content of unsaturated double bonds being no less than 4 × 10⁻⁴ mol/g and no greater than 23 × 10⁻⁴ mol/g. The content of the unsaturated double binding is preferably no less than 6 × 10⁻⁴ mol/g and no greater than 20 × 10⁻⁴ mol/g, and more preferably no less than 8 × 10⁻⁴ mol/g and no greater than 17 × 10⁻⁴ mol/g.

In addition, with respect to the blending proportion of the cycloolefin resin (A) to the elastomer ingredient (B), it falls within the range of no less than 60 parts by mass and no more than 90 parts by mass of the cycloolefin resin (A) to no less than 10 parts by mass and no more than 40 parts by mass of the elastomer ingredient (B). Moreover, the blending proportion falls within the range of preferably no less than 65 parts by mass and no more than 88 parts by mass of the cycloolefin resin (A) to no less than 12 parts by mass and no more than 35 parts by mass of the elastomer ingredient (B), and more preferably no less than 70 parts by mass and no more than 85 parts by mass of the cycloolefin resin (A) to no less than 15 parts by mass and no more than 30 parts by mass of the elastomer ingredient (B).

The elastomer ingredient (B) used in the material for high-frequency use electronic parts of the present invention is not particularly limited, but it preferably includes styrene as a polymer component, in light of miscibility with the cycloolefin resin (A).

In addition, as the elastomer ingredient (B) used in the present invention, a mixture of (b1) an elastomer having unsaturated bonds, and (b2) an elastomer not substantially having an unsaturated bond is preferred.

Herein, the "elastomer not substantially having an unsaturated bond (b2)" indicates to include, in addition to an elastomer not having an unsaturated bond immediately after the polymerization, also a hydrogenated elastomer obtained by hydrogenation of the unsaturated bond of an elastomer having unsaturated bonds. In addition, when a part of the unsaturated bond of the elastomer having unsaturated bonds is hydrogenated, while a part of the unsaturated bond remains unchanged, such an elastomer ingredient may be referred to as a mixture of the elastomer having unsaturated bonds (b1) and the elastomer not substantially having an unsaturated bond (b2).

In other words, the term "a mixture of (b1) an elastomer having unsaturated bonds and (b2) an elastomer not substantially having an unsaturated bond" to be the elastomer ingredient (B) of the present invention may be: a blend of an elastomer having unsaturated bonds and an elastomer not having an unsaturated bond; an elastomer having unsaturated bonds in which a part of the unsaturated bond is hydrogenated; or an elastomer not having an unsaturated bond which was partially oxidized to have a predetermined content of the unsaturated bond.

Specific examples of the elastomer ingredient (B) used in the present invention include, e.g., olefin based, styrene based, ester based, amide based, and urethane based thermoplastic elastomers. Among them, styrene based elastomers can be suitably used due to their high miscibility with the cycloolefin resin as described above.

Specific examples of the styrene based elastomer preferred as the elastomer ingredient (B) used in the present invention include, e.g., SEBS (polystyrene-ethylene/butylene-styrene), SEPS (polystyrene-poly(ethylene/propylene)block-polystyrene), SEEPS (polystyrene-poly(ethylene-ethylene/propylene)block-polystyrene), SEBS (polystyrene-poly(ethylene /butylene )block-polystyrene), SEP (polystyrene-poly(ethylene/propylene)block), and the like.

Furthermore, among the styrene based elastomers, mixtures including (b1') a styrene copolymer and (b2') a hydrogenated product of the styrene copolymer are preferred, and mixtures including (b1'') a styrene-butadiene-styrene block copolymer (SBS) and a styrene-ethylene butylene-styrene block copolymer (b2'') (also referred to as SEBS) that is a hydrogenated product of SBS are most preferred.

### Other Components

To the cycloolefin resin of the present invention can be added other thermoplastic resins, various compounding agents, and the like as needed, within a range not impairing its characteristics.

### Other Thermoplastic Resin

Other thermoplastic resins can include, for example, in addition to polyphenylene sulfide, polyphenylene ether, polyether sulfone, polysulfone, polycarbonate, polyacetal, and the like, polyester based polymers such as aromatic polyesters, polyarylate, polyethylene terephthalate, polybutylene terephthalate, and liquid crystalline polymers; polyolefin based polymers such as polyethylene, polypropylene, and poly-4-methylpentene-1; polyamide based polymers such as nylon 6, nylon 66, and aromatic nylon; polymethyl methacrylate, polyacrylonitrile-styrene (AS resin), polystyrene, and the like.

### Various Compounding Agents

Various compounding agents are not especially limited as long as they are ordinarily used in thermoplastic resin materials, and can include, for example, compounding agents such as antioxidants, ultraviolet absorbers, light stabilizers, plasticizers, lubricants, antistatic agents, flame retardants, coloring agents such as dyes and pigments, near-infrared ray absorbents, and fluorescent brightener.

### Method for Manufacturing Material for High-frequency Use Electronic Parts

The method for manufacturing the material for high-frequency use electronic parts of the present invention is not particularly limited, and a well known method can be employed. For example, a method of melting and kneading, simultaneously or successively, the cycloolefin resin (A), the elastomer ingredient (B), or in addition, resins and the like, which are blended as needed, can be exemplified. The method of melting and kneading can include, for example, methods for melting and kneading by a single screw extruder or twin screw extruder, Banbury mixer, roll, various kneaders and the like, after the resin composition is dry blended. The temperature for melting and kneading is not particularly limited as long as the cycloolefin resin (A), the elastomer ingredient (B), and the resins and the like which are blended as needed are melted. However, melting and kneading are generally carried out at temperatures in the range of typically 160 to 350°C, and preferably 180 to 300°C.

### Molded Product Obtained from Material for High-frequency Use Electronic Parts

It is preferred that the dielectric loss (tan δ) of the material for high-frequency use electronic parts of the present invention measured according to determination by cavity resonance with a method of perturbation at 5.8 GHz be no greater than 13 × 10⁻⁴. The dielectric loss (tan δ) at 5.8 GHz is more preferably no greater than 11 × 10⁻⁴, and particularly preferably no greater than 9 × 10⁻⁴.

In addition, the material for electronic parts for high-frequency of the present invention preferably has a Charpy impact value of no less than 20 kJ/m² as determined in accordance with ISO179/1eA. The Charpy impact value is more preferably no less than 25 kJ/m², and particularly preferably no less than 30 kJ/m².

The material for high-frequency use electronic parts of the present invention preferably has an adhesion strength of plating being no less than 0.6 N/mm as determined when the material is formed into a molded product having a length of 70 mm, a width of 70 mm and a thickness of 2 mm, and subjected to etching at 60°C for no longer than 1 hour in an aqueous chromic acid solution that is a mixture of 300 g/L chromic acid and 350 g/L sulfuric acid.

In light of the productivity, the etching time period is preferably as short as possible, and thus it is preferred that sufficient plating and plating adhesion is obtained within a short period of time. The etching time period is preferably no longer than 1 hour, more preferably no longer than 50 min, and most preferably no longer than 40 min.

Accordingly, the molded product obtained from the material for high-frequency use electronic parts of the present invention can be suitably used as a variety of high-frequency use electronic parts, and can be used in, for example, antennas, connectors, switches, filters, converters, couplers, circulators, isolators, capacitors, inductors, coils, resonators, FPC for high-frequency use, and the like.

### Method for Forming Electronic Circuit

The method for producing an electronic circuit for high-frequency use of the present invention is not particularly limited, and methods usually employed for electronic parts can be employed appropriately. Examples of such methods include chemical plating (nonelectrolytic plating), electroplating, metal insert, and the like. In addition, the electronic circuits can also be provided not only on the surface of the molded product by a method of covering the plated surface with a resin, but also inside of the molded product by a method of using an insert metal, and the like.

Examples of the chemical plating (nonelectrolytic plating) include, e.g., plating with copper, tin, nickel, indium, rhodium, ruthenium, palladium, gold, or an alloy of these metals, and alloy plating with a nickel-phosphorus system, a nickel-boron system, a cobalt-phosphorus system, a cobalt-molybdenum system, and the like. In the field of electronic materials, to use nickel, copper, or gold is preferable among these.

Additionally, examples of the electroplating include, e.g., plating with copper, nickel, tin, palladium, gold, silver, rhodium, chromium, or an alloy of these metals, and alloy plating with a tin-lead alloy, a nickel-phosphorus alloy, and the like. Similarly to chemical plating, nickel, copper, gold or the like is preferably used also for the electroplating in the field of electronic materials.

### EXAMPLES

The present invention is described in detail below with reference to Examples and Comparative Examples, but the present invention is not to be limited thereto.

### Various Materials

Various materials used in Examples and Comparative Examples are presented below.
(A) Cycloolefin Resin
   Trade name: ZEONEX(R) 480R (cycloolefin polymer), manufactured by Nippon ZEON Co., Ltd.
   Trade name: TOPAS6013 (cycloolefin copolymer), manufactured by TICONA
(B) Elastomer Ingredient
   (b1) Elastomer Having Unsaturated Bonds
   SBS (styrene / butadiene = 7/3), manufactured by Kraton Corporation
   (b2) Elastomer not Having an Unsaturated Bond
   SEBS (styrene/ethylene-butylene = 33/67), manufactured by Clayton Corporation

### Measurement and Evaluation Method

The measurement and evaluation methods of various properties in the present Examples and Comparative Examples will be described below.

### Content of Unsaturated Double Bond

In Examples and Comparative Examples, the content of the unsaturated double bonds was determined by an iodine value method (in accordance with JISK6235) on a mixture ((B) elastomer ingredient) of the elastomer having unsaturated bonds (b1) and the elastomer not having an unsaturated bond (b2).

### Charpy Impact Value

Using an electric molding machine with a mold clamping force of 75 t (SE75D, manufactured by Sumitomo Heavy Industries, Ltd.), a strip of 4 mm × 10 mm width was formed at a cylinder temperature of 280°C, and a mold temperature of 120°C. The resultant strip was provided with a notch, and thereafter evaluated in an atmosphere of 23°C and 50% RH using a Charpy impact value measuring device manufactured by Toyo Seiki Seisaku-sho, Ltd., in accordance with ISO179/1eA. Dielectric Loss (tan δ)

Using an electric forming machine with a mold clamping force of 75 t (SE75D, manufactured by Sumitomo Heavy Industries, Ltd.), a bar of 1 mm sides × 50 mm length was formed at a cylinder temperature of 280°C, and a mold temperature of 120°C. The resultant bar was evaluated in an atmosphere of 23°C and 50% RH using a resonator manufactured by Kantoh Electronics Application and Development Inc., Swept CW Generator 83650L manufactured by Agilent Technologies, Inc., and Scalor Network Analyzer 8758D manufactured by Agilent Technologies, Inc. according to determination by cavity resonance with a method of perturbation.

### Adhesion Strength of Metal Plating

With respect to the adhesion strength of metal plating, the sample was produced, etched, and subjected to metal plating according to the following procedures. The adhesion strength of the resultant metal plating was determined. Formation of Sample

Using a side gate flat plate of 70 mm × 70 mm with a thickness of 2 mm as a mold, a flat board was formed from an electric molding machine with a mold clamping force of 75 t (SE75D, manufactured by Sumitomo Heavy Industries, Ltd.), at a cylinder temperature of 280°C, a mold temperature of 120°C, and at an injection speed of 3 m/min. Degreasing Step

The resultant flat board was subjected to the following degreasing step.
1. Degreasing: Subjecting the resultant flat board to an immersion treatment in ACECLEAN A220 (trade name) manufactured by Okuno Chemical Industries Corporation at 60°C for 5 min
2. Water Rinsing

### Chromic Acid Etching Step

The flat board following the degreasing step was subjected to a chromic acid etching step.
1. Treatment with Chromic Acid: Immersion treatment in an aqueous chromic acid solution (chromic acid 300 g/L + sulfuric acid 350 g/L) at 60°C for one hour
2. Water Rinsing
3. Ultrasonic Cleaning: Treatment with tap water at room temperature for one minute (ultrasonic cleaning apparatus: manufactured by Kaijo Denki Co. Ltd., trade name: Sono Cleaner 200a, frequency: 38 kHz, output: 0.36 W/cm² (the following ultrasonic cleaning is carried out under the same condition))
4. Water Rinsing
5. Neutralization: Neutralization with an immersion treatment in a 1 mol/L aqueous potassium hydroxide solution at room temperature for 3 min
6. Water Rinsing

### Wet Copper Plating Step

The flat board etched in the etching step was subjected to wet copper plating according to the following step.
1. Conditioning: Immersion treatment in OPC-350 conditioner (trade name, manufactured by Okuno Chemical Industries Corporation) at room temperature for 3 min
2. Water Rinsing
3. Catalyzing: Immersion treatment in A-30 catalyst (trade name, manufactured by Okuno Chemical Industries Corporation) at room temperature for 3 min
4. Water Rinsing
5. Activation: Immersion treatment in a 5% by volume aqueous hydrochloric acid solution at room temperature for 2 min
6. Water Rinsing
7. Nonelctrolytic Plating: Immersion treatment in an aqueous nonelectrolytic plating solution (trade name: OPC-750 manufactured by Okuno Chemical Industries Corporation) at room temperature for 20 min
8. Water Rinsing
9. Conditioning: Immersion treatment in OPC-350 conditioner (trade name, manufactured by Okuno Chemical Industries Corporation) at room temperature for 3 min
10. Water Rinsing
11. Surface Activation: Immersion treatment in a 5% by weight aqueous sulfuric acid solution at room temperature for 3 min
12. Water Rinsing
13. Electroplating: Treatment of immersing in a mixed aqueous solution of 10% by weight sulfuric acid, 10% by weight copper sulfate and 0.1% by volume of 1 N hydrochloric acid at room temperature, and applying an electric current of 4 A/dm² with the cathode connected to the nonelectrolytic plating sample and the anode connected to copper until the deposited product gave a film thickness of 30 µm
14. Water Rinsing
15. Conditioning: Immersion treatment in the OPC-350 conditioner (trade name, manufactured by Okuno Chemical Industries Corporation) at room temperature for 3 min
16. Water Rinsing
17. Drying: Air drying after washing with acetone

### Plating Adhesion

The flat board subjected to the wet copper plating treatment was cut using a retractable knife to give a strip cut having a width of 1 cm. Subsequently, one end of the plated metal layer was pulled up to an angle of 90°, and the tip was pinched with a spring scale to determine the force in peeling the plated layer as a plating adhesion (N/mm). Furthermore, this evaluation was performed on five pieces of the sample, respectively, and the mean value was determined. Example 1

With the proportion shown in Table 1, the cycloolefin resin (A), the elastomer having unsaturated bonds (b1), and the elastomer not having an unsaturated bond (b2) were extruded using an extruder (TEX30 manufactured by Japan Steel Works, Ltd.) at a cylinder temperature of 250°C, a screw rotation speed of 150 rpm, and an extrusion capacity of 10 kg/h, whereby a pellet was produced. Subsequently, the resulting pellet was dried at 100°C for 6 hrs, and thereafter a variety of measurements and evaluations were performed using the dried pellet. The results are shown in Table 1.

### Examples 2 to 8 and Comparative Examples 1 to 7

The pellets were produced in a similar manner to Example 1 with the materials and compounding formulations shown in Table 1 and Table 2, and then drying was performed. Subsequently, a variety of measurements and evaluations were performed using the resulting pellet similarly to Example 1. The results are summarized in Table 1 and Table 2.

**Table 1**

| | Example 1 | Example 2 | Example 3 | Example 4 | Example 5 | Example 6 | Example 7 | Example 8 |
|---|---|---|---|---|---|---|---|---|
| ZEONEX (% by mass) | | | | | | 90 | 70 | 60 |
| TOPAS (% by mass) | 90 | 80 | 70 | 70 | 60 | | | |
| SBS (% by mass) | 5 | 10 | 15 | 25 | 5 | 5 | 25 | 5 |
| SEBS (% by mass) | 5 | 10 | 15 | 5 | 35 | 5 | 5 | 35 |
| Content of unsaturated double bond (× 10⁻⁴ mol/ g) | 4.5 | 9.1 | 13.6 | 22.7 | 4.5 | 4.5 | 22.7 | 4.5 |
| Charpy impact value (kJ/m²) | 24 | 33 | 55 | 48 | 75 | 25 | 49 | 78 |
| Dielectric loss: 1 GHz (× 10⁻⁴) | 6 | 8 | 9 | 13 | 5 | 6 | 12 | 5 |
| Dielectric loss: 3 GHz (× 10⁻⁴) | 5 | 7 | 10 | 12 | 4 | 5 | 12 | 4 |
| Dielectric loss: 5.8 GHz (× 10⁻⁴) | 5 | 7 | 9 | 10 | 4 | 5 | 11 | 4 |
| Dielectric loss: 10 GHz (× 10⁻⁴) | 4 | 6 | 8 | 9 | 4 | 4 | 10 | 4 |
| Plating adhesion (N/mm) | 0.64 | 0.77 | 0.82 | 1.00 | 0.67 | 0.65 | 0.98 | 0.65 |

**Table 2**

| | Comparative Example 1 | Comparative Example 2 | Comparative Example 3 | Comparative Example 4 | Comparative Example 5 | Comparative Example 6 | Comparative Example 7 |
|---|---|---|---|---|---|---|---|
| ZEONEX (% by mass) | | | | | | 70 | |
| TOPAS (% by mass) | 70 | 70 | 100 | 90 | 65 | | 55 |
| SBS (% by mass) | 30 | | | 10 | 30 | | 10 |
| SEBS (% by mass) | | 30 | | | 5 | 30 | 35 |
| Content of unsaturated double bond (x 10⁻⁴ mol/ g) | 27.2 | 0 | 0 | 91 | 27.2 | 0 | 9.1 |
| Charpy impact value (kJ/m²) | 44 | 67 | 2 | 15 | 50 | 70 | - |
| Dielectric loss: 1 GHz (x 10⁻⁴) | 18 | 1 | 4 | 9 | 17 | 1 | - |
| Dielectric loss: 3 GHz (x 10⁻⁴) | 17 | 1 | 4 | 8 | 16 | 1 | - |
| Dielectric loss: 5.8 GHz (x 10⁻⁴) | 15 | 1 | 4 | 7 | 15 | 1 | - |
| Dielectric loss: 10 GHz (x 10⁻⁴) | 14 | 1 | 4 | 6 | 14 | 1 | - |
| Plating adhesion (N/mm) | 1.02 | 0.30 | 0.00 | 0.67 | 1.00 | 0.28 | - |
| Remarks | | | | | | | molding failed |

### INDUSTRIAL APPLICABILITY

The material for high-frequency use electronic parts of the present invention serves as a material having dielectric properties suitable for use in a high-frequency region, satisfactory plating, high adhesion to metal deposit layers and also superior impact resistance. Accordingly, the high-frequency use electronic parts obtained from the material for high-frequency use electronic parts of the present invention can include, for example, antennas, connectors, switches, filters, converters, couplers, circulators, isolators, capacitors, inductors, coils, resonators, FPC for high-frequency use, and the like.

## Claims

1. A material for high-frequency use electronic parts which comprises no less than 60 parts by mass and no more than 90 parts by mass of (A) a cycloolefin resin containing a cycloolefin component as a copolymer component, and no less than 10 parts by mass and no more than 40 parts by mass of (B) an elastomer component, wherein
the content of the unsaturated double bonds in the elastomer component (B) determined by an iodine value method (in accordance with JIS K 6235) is no less than 4 × 10⁻⁴ mol/g and no greater than 23 × 10⁻⁴ mol/g, and
the dielectric loss (tan δ) of the molded product composed of the material for high-frequency use electronic parts, measured according to determination by cavity resonance with a method of perturbation at 1 to 10 GHz, is no greater than 13 × 10⁻⁴.

2. The material for high-frequency use electronic parts according to claim 1, wherein the elastomer ingredient (B) comprises styrene as a polymer component.

3. The material for high-frequency use electronic parts according to claim 1, wherein the elastomer component (B) is a mixture of (b1) an elastomer having unsaturated bonds and (b2) an elastomer not substantially having an unsaturated bond.

4. The material for high-frequency use electronic parts according to claim 1, wherein the elastomer component (B) is a mixture comprising (b1') a styrene copolymer and (b2') a hydrogenated product of the styrene copolymer.

5. The material for high-frequency use electronic parts according to claim 1, wherein the elastomer component (B) is a mixture comprising (b1'') a styrene-butadiene-styrene block copolymer (hereinafter, also referred to as SBS) and (b2") a styrene-ethylene butylene-styrene block copolymer (hereinafter, also referred to as SEBS).

6. The material for high-frequency use electronic parts according to claim 1, wherein a Charpy impact value determined in accordance with ISO179/1eA is no less than 20 kJ/m².

7. The material for high-frequency use electronic parts according to claim 1, wherein an adhesion strength of plating is no less than 0.6 N/mm as determined when the material is formed into a molded product having a length of 70 mm, a width of 70 mm and a thickness of 2 mm, and subjected to etching at 60°C for no longer than 1 hour in an aqueous chromic acid solution that is a mixture of 300 g/L chromic acid and 350 g/L sulfuric acid.

8. A high-frequency use electronic part composed of the material for high-frequency use electronic parts according to claim 1.

9. The high-frequency use electronic part according to claim 8, wherein the high-frequency use electronic part is subjected to metal plating on a portion of at least one of a surface and an interior.

## Patentansprüche

1. Werkstoff für elektronische Teile für den Hochfrequenzeinsatz, der mindestens 60 Massenteile und höchstens 90 Massenteile (A) eines Cycloolefinharzes mit einer Cycloolefinkomponente als Copolymerkomponente und mindestens 10 Massenteile und höchstens 40 Massenteile (B) einer Elastomerkomponente enthält, wobei
der nach einer Iodzahlmethode (gemäß JIS K 6235) bestimmte Gehalt der ungesättigten Doppelbindungen in der Elastomerkomponente (B) mindestens 4 x 10⁻⁴ mol/g und höchstens 23 x 10⁻⁴ mol/g beträgt und
der gemäß der Bestimmung durch Hohlraumresonanz nach einer Störungsmethode bei 1 bis 10 GHz gemessene dielektrische Verlust (tan δ) des Formprodukts aus dem Werkstoff für elektronische Teile für den Hochfrequenzeinsatz höchstens 13 x 10⁻⁴ beträgt.

2. Werkstoff für elektronische Teile für den Hochfrequenzeinsatz nach Anspruch 1, wobei der Elastomerbestandteil (B) Styrol als Polymerkomponente umfaßt.

3. Werkstoff für elektronische Teile für den Hochfrequenzeinsatz nach Anspruch 1, wobei es sich bei der Elastomerkomponente (B) um eine Mischung von (b1) einem Elastomer mit ungesättigten Bindungen und (b2) einem Elastomer, das weitgehend keine ungesättigte Bindung aufweist, handelt.

4. Werkstoff für elektronische Teile für den Hochfrequenzeinsatz nach Anspruch 1, wobei es sich bei der Elastomerkomponente (B) um eine Mischung von (b1') einem Styrolcopolymer und (b2') einem hydrierten Produkt des Styrolcopolymers handelt.

5. Werkstoff für elektronische Teile für den Hochfrequenzeinsatz nach Anspruch 1, wobei es sich bei der Elastomerkomponente (B) um eine Mischung von (b1") einem Styrol-Butadien-Styrol-Blockcopolymer (das im folgenden auch als SBS bezeichnet wird) und (b2") einem Styrol-Ethylen/Butylen-Styrol-Blockcopolymer (das im folgenden auch als SEBS bezeichnet wird) handelt.

6. Werkstoff für elektronische Teile für den Hochfrequenzeinsatz nach Anspruch 1, wobei ein gemäß ISO 179/1eA bestimmter Charpy-Schlagzähigkeitswert mindestens 20 kJ/m² beträgt.

7. Werkstoff für elektronische Teile für den Hochfrequenzeinsatz nach Anspruch 1, wobei die Haftfestigkeit von Plattierung bei Bestimmung bei Formen des Werkstoffs zu einem Formprodukt mit einer Länge von 70 mm, einer Breite von 70 mm und einer Dicke von 2 mm und Ätzen bei 60°C über einen Zeitraum von höchstens 1 Stunde in wäßriger Chromsäurelösung, bei der es sich um eine Mischung von 300 g/L Chromsäure und 350 g/L Schwefelsäure handelt, mindestens 0,6 N/mm beträgt.

8. Elektronisches Teil für den Hochfrequenzeinsatz aus dem Werkstoff für elektronische Teile für den Hochfrequenzeinsatz nach Anspruch 1.

9. Elektronisches Teil für den Hochfrequenzeinsatz nach Anspruch 8, wobei das elektronische Teil für den Hochfrequenzeinsatz auf einem Teil einer Oberfläche und/oder eines Inneren einer Metallplattierung unterworfen wird.

## Revendications

1. Un matériau pour pièces électroniques destinées à être utilisées sous hautes fréquences, qui comprend pas moins de 60 parties en masse et pas plus de 90 parties en masse d'une résine cyclooléfinique (A) contenant un composant cyclooléfinique en tant que composant copolymère et pas moins de 10 parties en masse et pas plus de 40 parties en masse d'un composant élastomère (B),
matériau dans lequel
- la teneur en double liaisons insaturées dans le composant élastomère (B), déterminée par la méthode de détermination de l'indice d'iode (selon la norme JIS K 6235), n'est pas inférieure à 4 x 10⁻⁴ mol/g et pas supérieure à 23 x 10⁻⁴ mol/g,
- et la perte diélectrique (tan δ) du produit moulé formé du matériau pour pièces électroniques destinées à être utilisées sous hautes fréquences, mesurée par détermination par résonance de la cavité par la méthode de la théorie des perturbations sous 1 à 10 GHz, n'est pas supérieure à 13 x 10⁻⁴.

2. Le matériau pour pièces électroniques destinées à être utilisées sous hautes fréquences selon la revendication 1, dans lequel les constituants de l'élastomère (B) comprennent du styrène en tant que composant polymère.

3. Le matériau pour pièces électroniques destinées à être utilisées sous hautes fréquences selon la revendication 1, dans lequel l'élastomère (B) est un mélange d'un élastomère (b1) comportant des liaisons insaturées et un élastomère (b2) ne comportant pratiquement pas de liaison insaturée.

4. Le matériau pour pièces électroniques destinées à être utilisées sous hautes fréquences selon la revendication 1, dans lequel le composant élastomère (B) est un mélange comprenant un copolymère styrénique (b1') et un produit hydrogéné (b2') du copolymère styrénique.

5. Le matériau pour pièces électroniques destinées à être utilisées sous hautes fréquences selon la revendication 1, dans lequel le composant élastomère (B) est un mélange comprenant un copolymère séquencé styrène-butadiene-styrène (b1") (appelé ci-dessous SBS) et un copolymère séquencé styrène-éthylène-butylène-styrène (b2") (appelé ci-dessous SEBS).

6. Le matériau pour pièces électroniques destinées à être utilisées sous hautes fréquences selon la revendication 1, dans lequel la valeur obtenue par un test de résilience Charpy, déterminée selon la norme ISO179/1eA n'est pas inférieure à 20 kJ/m².

7. Le matériau pour pièces électroniques destinées à être utilisées sous hautes fréquences selon la revendication 1, dans lequel le force d'adhérence du placage, telle que déterminée lorsque le matériau est sous forme d'un produit moulé dont la longueur est de 70 mm, la largeur de 70 mm et l'épaisseur de 2 mm, n'est pas inférieure à 0,6 N/mm, et dans lequel le matériau est soumis à un décapage à 60°C pendant pas plus de 1 heure dans une solution aqueuse d'acide chromique consistant en un mélange de 300 g/l d'acide chromique et 350 g/l d'acide sulfurique.

8. Une pièce électronique destinée à être utilisée sous hautes fréquences composée du matériau pour pièces électroniques destinées à être utilisées sous hautes fréquences selon la revendication 1.

9. La pièce électronique destinée à être utilisée sous hautes fréquences selon la revendication 8, dans lequel la pièce électronique destinée à être utilisée sous hautes fréquences subit un placage métallique sur une partie d'au moins une parmi sa surface externe et sa surface interne.
